# EUROPÄISCHE PATENTANMELDUNG

(11) **EP 4 624 945 A1**
(43) Veröffentlichungstag der Anmeldung: **01.10.2025**
(21) Anmeldenummer: 24166888.8
(22) Anmeldetag: 27.03.2024
(51) Int. Cl.: G01R 29/08, G01R 29/12, G01R 31/28

(54) **ÜBERWACHUNG EINER ELEKTRONISCHEN BAUGRUPPE MITTELS ELEKTRISCHER FELDMESSUNG**

(71) Anmelder: Siemens Aktiengesellschaft, 80333 München (DE)
(72) Erfinder: Bickel, Heinz Dietrich Philipp, 81677 München (DE); Kriegel, Kai, 81739 München (DE); Mitic, Gerhard, 81827 München (DE); Stegmeier, Stefan, 81825 München (DE); Walbrecker-Baar, Christian, 85757 Karlsfeld (DE)
(74) Vertreter: Siemens Patent Attorneys

(57) **Zusammenfassung**

Die Erfindung betrifft ein Verfahren zur Überwachung einer elektronischen Baugruppe, ein Bauelement angeordnet mit einer Überwachungseinrichtung sowie eine elektronische Baugruppe. Es wird vorgeschlagen eine elektrische Feldmessung vorzunehmen, bei welcher ein elektrisches Feld (E, E(t)) wenigstens eines Bauelements (11) der elektronischen Baugruppe (10) erfasst und ausgewertet wird. Eine derartige Messung indiziert direkt Änderungen an der Baugruppe (10). Zur elektrischen Feldmessung werden bevorzugt mikroelektromechanische Feldmühlen oder Elektroskope (F₁-Fₙ) eingesetzt.

## Beschreibung

Die vorliegende Erfindung betrifft ein Verfahren zur Überwachung einer elektronischen Baugruppe, ein Bauelement angeordnet mit einer Überwachungseinrichtung sowie eine elektronische Baugruppe.

### Stand der Technik

Aktuell wird die Lebensdauer von elektronischen Baugruppen, insbesondere leistungselektronischen Baugruppen und deren Leistungshalbleitermodulen abgeschätzt. Beispielsweise wird bereits bei der Entwicklung der Bauteile und der einzelnen Module und bei der Herstellung Baugruppe über verschiedene Alterungstests eine Lebensdauer prognostiziert. Dabei können beispielsweise beschleunigte Alterungstests wie Lastzyklentests oder Temperaturzyklentests angewendet werden. In standardisierten Tests wird dabei eine bestimmte Zyklenzahl definiert, die eine Baugruppe, ein Bauelement oder ein Modul einer Baugruppe durchlaufen muss, und nach welcher Zyklenzahl weiterhin die Funktion von Baugruppe, Bauelement oder Modul gegeben sein muss.

Auch Temperaturmessungen kommen dabei zum Einsatz und mittels mathematischer Wahrscheinlichkeitsverteilungen wird ein ungefährer Alterungsgrad vorausgesagt. Zur Überprüfung der beschriebenen Alterung kann nach den beschleunigten Alterungstests beispielsweise ein Öffnen des Moduls oder der Baugruppe oder des Bauelements von Nöten sein. Insbesondere muss zum Nachweis der beschleunigten Alterung ein Schliff erfolgen.

Die Lebensdauer von elektronischen Baugruppen, insbesondere von leistungselektronischen Baugruppen, wird im Wesentlichen durch die Belastung im Betrieb und die mit der Bestromung der Baugruppe einhergehenden Temperaturhüben begrenzt. Durch unterschiedliche Ausdehnungskoeffizienten der Aufbaumaterialien einer elektronischen Baugruppe oder eines Bauelements entstehen im Bereich der Materialverbindungen thermisch induzierte mechanische Spannungen, die zu Rissen, Delaminationen oder Fehlstellen führen können. Die häufigsten Ausfallursachen sind die Bonddrähte und die Lotschichten, an denen Risse oder ein Abheben entstehen. Die Lebensdauer derartiger Materialverbindungen endet mit einem vollständigen Durchreißen oder Lift-off der Bondverbindung. Auch in den Lotschichten entstehen Risse, Delaminationen und Fehlstellen. Derartige Alterungserscheinungen können im verschlossenen Modul bzw. in einer geschlossenen Baugruppe nur schwer erkannt werden, insbesondere nicht während des Betriebs der Baugruppe.

Es wird versucht die beschriebenen Alterungserscheinungen über temperatursensitive Parameter zu bestimmen. Durch Delaminationen in der Lotschicht ändert sich beispielsweise die Wärmeableitung. Demnach ändert sich auch die Schwellspannung oder der Einschaltwiderstand des Bauteils und lässt auf eine alterungsbedingte Fehlstelle, beispielsweise eine Delamination schließen.

Es werden diverse technische Verfahren angewandt, beispielsweise bildgebende Verfahren wie Röntgen, Ultraschallmikroskopie oder Thermografie, mittels welcher man die beschriebenen Alterungserscheinungen bildgebend darstellen kann, insbesondere ortsaufgelöst darstellen kann. Diese Verfahren sind jedoch sehr aufwändig und nicht oder nur bedingt im laufenden Betrieb des Bauteils oder der Baugruppe anwendbar.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine zuverlässige Überwachung des Bauteils, auch im Betrieb, ermöglichen.

Diese der vorliegenden Erfindung zugrundeliegende Aufgabe wird durch ein Verfahren gemäß dem Patentanspruch 1 gelöst. Vorteilhafte Ausgestaltungen der Erfindung sind Gegenstand der Unteransprüche.

### Beschreibung der Erfindung

Das erfindungsgemäße Verfahren zur Überwachung einer elektronischen Baugruppe umfasst eine elektrische Feldmessung, welche derart vorgenommen wird, dass dabei ein statisches elektrisches Feld und/oder ein zeitlich veränderliches elektrisches Feld, welches von wenigstens einem stromführenden Abschnitt, Bauteil oder Bauelement der elektronischen Baugruppe ausgeht, erfasst wird, und die dabei erfassten elektrischen Felddaten in einem Signalanalyseschritt ausgewertet werden, um auf Änderungen am Bauelement zu schließen. Dieses Verfahren zur Überwachung hat den Vorteil, im Gegensatz zu einer Prüfung zu nur diskreten Zeitpunkten oder im Nachgang des Betriebs, kontinuierlich im Prozess, während des Betriebs der Baugruppe eine Überwachung zu gewährleisten. Mittels der elektrischen Feldmessung kann ein statisches elektrisches Feld, ein zeitlich veränderliches elektrisches Feld sowie beides erfasst werden, welches im Betrieb der elektrischen Baugruppe von wenigstens einem Element der elektrischen Baugruppe ausgeht. Die erfassten elektrischen Felddaten können in einem Messauswertungsverfahren kontinuierlich ausgewertet werden und Änderungen am Bauelement indizieren. Insbesondere indizieren die gemessenen und ausgewerteten Daten direkt Änderungen am Bauelement, Schäden oder Delaminationen der Bonddrähte und/oder der Lotschichten. Es handelt sich hierbei um eine direkte Bestimmung eines Defekts anhand eines momentanen zeitaktuellen Messwertes. Anhand des momentanen Messwertes wird direkt ein Defekt erkannt, anders als bei Wahrscheinlichkeitsrechnungen und Abschätzungsmodellen, die auf beschleunigten Alterungsverfahren beruhen. Außerdem handelt es sich um ein direktes Messverfahren im laufenden Betrieb und nicht um eine Testung oder Überprüfung eines Feldrückläufers. Dabei kann die elektrische Feldmessung zwar zu diskreten Zeitpunkten vorgenommen werden, aber auch kontinuierlich. Die Signalanalyse bzw. Messauswertung kann kontinuierlich mitgeschrieben werden. Es können auch Grenzwerte festgelegt sein, die eine Anzeige des überschrittenen Grenzwerts nach sich ziehen, insbesondere ein Datensignal.

Im folgenden wird unter der Formulierung, dass ein von einem zu überwachenden Bauelement im Betrieb ausgehendes elektrisches Feld gemessen wird, verstanden, dass zumindest ein elektrisch stromführender und/oder elektrische Ladung tragender Abschnitt eines Bauelements, einer Bauelementanbindung, eines Baugruppenmoduls etc. ein elektrisches Feld erzeugt.

In einer vorteilhaften Ausführungsform der Erfindung wird in dem Verfahren die elektrische Feldmessung mittels einer elektrischen Feldmühle, insbesondere mittels einer mikroelektromechanischen Feldmühle vorgenommen. Eine Feldmühle kann ein statisches sowie ein zeitlich veränderliches elektrisches Feld detektieren. Durch Alterungserscheinungen in den Bonddrähten oder den Lotschichten ergibt sich eine veränderte Charakteristik des statischen und des zeitabhängigen elektrischen Feldes. Insbesondere können die gemessenen Daten mit Referenzdaten abgeglichen werden. Zwei gegeneinander bewegliche Kondensatorplatten, eine bevorzugt fixiert angeordnete und eine bevorzugt in einer Fingerelektrodenstruktur ausgeführte, werden mit vorgebbarer Geschwindigkeit und Frequenz gegeneinander bewegt. Durch die abwechselnd dem elektrischen Feld ausgesetzte Elektrodenanordnung ergibt sich eine durch das elektrische Feld bewirkte Ladungstrennung, welche als Strom detektiert werden kann.

Alternativ wird die elektrische Feldmessung mittels eines Elektroskops, insbesondere mittels eines mikroelektromechanischen Elektroskops vorgenommen. Auch bei dieser Messmethode werden durch das zu detektierende elektrische Feld bewirkte Ladungsverschiebungen registriert. Hier werden veränderliche Kapazitäten in einer Kondensatoranordnung aufgrund der Ladungsverschiebung gemessen.

Bevorzugt werden die erfassten elektrischen Felddaten in dem Messauswertungsverfahren mit Referenzdaten abgeglichen. Referenzdaten können dabei sein: Daten, die zu einem früheren Zeitpunkt aufgenommen wurden, insbesondere Daten, die unter Testbedingungen aufgenommen wurden. Referenzdaten können dabei auch Mittelwerte aus einer Datenhistorie sein.

In einem besonders vorteilhaften Vorgehen werden die Referenzdaten mittels einer Referenzmessung des elektrischen Feldes vor Inbetriebnahme der elektronischen Baugruppe aufgenommen. Eine Abweichung von den Referenzdaten ist dann eine besonders zuverlässige Indikation einer Änderung am Bauelement oder an der Baugruppe. Bei dem Verfahren können indizierte Änderungen am Bauelement oder an der Baugruppe Schäden oder Delaminationen der Bonddrähte und/oder der Lotschichten sein. Eine derartige direkte Bestimmung von Defekten anhand eines zeitaktuellen Messwertes ist von besonderem Vorteil in kritischen Anwendungsbereichen von elektronischen Baugruppen. Derartige Defekte können angezeigt werden und zu einem Austausch der Baugruppe veranlassen. Bisher waren nur Lebensdauerabschätzungen möglich, mittels des direkten Messverfahrens können Defekte sofort erkannt werden. Die elektrische Feldmessung kann zu diskreten Zeitpunkten vorgenommen werden, aber auch kontinuierlich im Betrieb der elektronischen Baugruppe vorgenommen werden. Dies hat den großen Vorteil gegenüber bisherigen Prüfungsverfahren, dass mit dem vorgeschlagenen Verfahren eine In-Situ-Überwachung der elektronischen Baugruppe gewährleistet ist.

Das erfindungsgemäße Verfahren wird bevorzugt beabstandet von der zu überwachenden elektronischen Baugruppe vorgenommen, wobei der Abstand zweckdienlicherweise so gewählt wird, dass das elektrische Feld zuverlässig detektiert werden kann. Auch bezüglich Referenzdatenabgleich ist eine reproduzierbar anordenbare Beabstandung der Überwachungsalso der Feldmesseinrichtung zur zu überwachenden elektronischen Baugruppe zu gewährleisten. Eine bevorzugte Variante der beabstandeten Feldmessung wird mittels einer Befestigung der Feldmesseinrichtung an einem mit der zu prüfenden elektronischen Baugruppe gemeinsamen Träger gewährleistet. Dieser gemeinsame Träger kann beispielsweise ein gemeinsames Substrat, z. B. eine gemeinsame Leiterplatte sein. Bevorzugt wird das Baugruppengehäuse als gemeinsamer Träger für elektronische Baugruppe und Feldmesseinrichtung hergenommen. Dies hat den besonderen Vorteil, dass die beabstandete Befestigung der Feldmesseinrichtung zur elektronischen Baugruppe im Deckel des Gehäuses vorgenommen werden kann. Derart angebrachte Feldmesseinrichtungen sind demnach galvanisch getrennt vom zu überwachenden Bauteil angeordnet, vor Spannungsüberschlägen geschützt, insbesondere mit einem Mindestabstand zum elektrischen Bauteil.

Erfindungsgemäß wird ein zu überwachendes elektronisches Bauelement, insbesondere ein Halbleitermodul oder Leistungshalbleitermodul, mit einer elektrischen Feldmesseinrichtung als Überwachungseinrichtung angeordnet. Diese elektrische Feldmesseinrichtung ist dabei ausgestaltet, ein vom zu überwachenden Bauelement im Betrieb ausgehendes elektrisches Feld zu messen und die erfassten elektrischen Felddaten an eine Messauswerteelektronik zu übertragen. Bei den so erfassten elektrischen Felddaten wird auch von den Überwachungsdaten gesprochen. Die Messauswerteelektronik, insbesondere eine Signalauswertung, kann mit dem Bauelement und mit der Feldmesseinrichtung angeordnet sein. Insbesondere kann die Messauswerteelektronik auch ein Signal an das Bauelement geben, insbesondere ein Abschaltsignal im Fehlerfall.

In einer vorteilhaften Ausführungsform der Erfindung ist das Bauelement mit einer elektrischen Feldmesseinrichtung angeordnet, welche eine elektrische Feldmühle, insbesondere eine mikroelektromechanische Feldmühle ist. Diese weist dabei wenigstens zwei Fingerelektroden, eine Elektrodenabschirmung und einen Aktuator auf, einen Stromspannungswandler sowie eine Signalausgabe. Alternativ kann die elektrische Feldmesseinrichtung ein Elektroskop, insbesondere ein mikroelektromechanisches Elektroskop sein. Das Elektroskop weist wenigstens zwei Elektroden, ein Dielektrikum zwischen den zwei Elektroden, eine Messchaltung zur Erfassung eines Lade- oder Entladestroms der zwei Elektroden sowie eine Signalausgabe auf.

Des Weiteren wird erfindungsgemäß eine elektronische Baugruppe beansprucht, insbesondere eine leistungselektronische Baugruppe, welche wenigstens ein erfindungsgemäßes Bauelement umfasst und in welcher wenigstens eine elektrische Feldmesseinrichtung an einem Träger befestigt ist, an welchem auch das zu prüfende elektronische Bauelement befestigt ist. Dies hat den Vorteil, dass eine exakte und reproduzierbare Beabstandung von Feldmesseinrichtung und zu prüfendem bzw. zu überwachendem elektronischem Bauelement gewährleistet ist. Bevorzugt kann als gemeinsamer Träger für zu überwachendes elektronisches Bauelement und elektrische Feldmesseinrichtung das Gehäuse der Baugruppe dienen. Besonders zweckdienlich ist eine Anordnung der elektrischen Feldmesseinrichtung im Gehäusedeckel. Alternativ kann die elektrische Feldmesseinrichtung zusammen mit dem zu überwachenden Bauelement in der Baugruppe angeordnet sein, beispielsweise auf einer gemeinsamen Platine. In dieser Ausführungsform muss auf eine galvanische Trennung von Bauelement u dessen elektrischer Anbindung an die Platine und elektrischer Feldüberwachungseinrichtung geachtet werden.

In einer weiteren vorteilhaften Ausführungsform der Erfindung umfasst die elektronische Baugruppe eine Messauswerteelektronik, welche derart ausgestaltet ist, die von wenigstens einer elektrischen Feldmesseinrichtung erfassten elektrischen Felddaten zu empfangen und auszuwerten.

Eine besonders vorteilhafte Ausführungsform der Erfindung sieht eine elektronische Baugruppe vor, welche eine Vielzahl an elektrischen Feldmesseinrichtungen umfasst und wo elektrische Feldmesseinrichtungen so in der elektronischen Baugruppe angeordnet sind, dass die damit erfassten elektrischen Felddaten in einen Messauswertungsvorgang ausgewertet werden und ortsaufgelöst Änderungen an der elektronischen Baugruppe indizieren. Bei der Anordnung der mehreren elektrischen Feldmesseinrichtungen kann entweder auf ein gleichmäßiges Anordnungsraster geachtet werden. Alternativ können Feldmesseinrichtungen in der Nähe besonders sensibler Bauelemente oder Baugruppenabschnitte angeordnet sein.

Vorteilhafterweise wird auch in dieser Ausführungsform das Gehäuse der elektronischen Baugruppe als gemeinsamer Träger genutzt: Dabei werden die elektrischen Feldmesseinrichtungen insbesondere so im Gehäusedeckel angebracht, dass die elektrischen Feldmesseinrichtungen in geschlossenem Zustand des Gehäuses geeignet beabstandet zu den zu prüfenden Bauelementen angeordnet sind.

Bevorzugt sind also zu überwachendes Bauelement, Bauteil oder Modul mit wenigstens einer elektrischen Feldmesseinrichtung baulich miteinander verbunden. Gleichzeitig aber so angeordnet, dass es nicht zu Spannungsüberschlägen kommen kann oder anderweitig eine elektrische Verbindung besteht. Es wird also ein Mindestabstand eingehalten. Gleichzeitig wird ein Höchstabstand eingehalten, sodass das vom zu überwachenden Bauteil, Bauelement, Modulabschnitt ausgehende elektrische Feld zuverlässig von der elektrischen Feldmesseinrichtung erfasst werden kann. Die gemeinsame Anbringung im Gehäuse ist dafür besonders geeignet.

Zusammenfassend kann festgehalten werden, dass ein Verfahren zur Überwachung einer elektronischen Baugruppe, einzelnen Baugruppenelements oder eines Baugruppenabschnitts vorgeschlagen wird, welches auf einer elektrischen Feldmessung beruht. Diese elektrische Feldmessung wird beabstandet vom zu überwachenden elektrischen Bauteil oder Baugruppenabschnitt vorgenommen und die Messdaten in einem Messauswertungsvorgang ausgewertet, sodass diese direkt Änderungen am zu überwachenden Bauelement indizieren. Zur elektrischen Feldmessung werden bevorzugt eine Feldmühle oder ein Elektroskop, insbesondere jeweils in mikroelektronischer Ausführung, verwendet. Erfindungsgemäß wird ein derartiges Verfahren durch Integration wenigstens einer elektrischen Feldmesseinrichtung bevorzugt mit einer entsprechenden Messauswerteelektronik in einer elektronische Baugruppe realisiert. Die Auswerteelektronik kann alternativ auch außerhalb der Baugruppe angeordnet sein.

Beispiele und Ausführungsformen der vorliegenden Erfindung werden noch in exemplarischer Weise mit Bezug auf die Figuren 1 bis 7 der angehängten Zeichnung beschrieben:
- Figur 1: zeigt eine schematische Darstellung eines Leistungsmoduls 10 in einem Gehäuse 20 platziert.
- Figur 2: zeigt schematisch den Gehäusedeckel und die darin angeordneten elektrischen Feldmesseinrichtungen F₁-Fₙ.
- Figur 3: zeigt schematisch die Elektrodenanordnung 31 einer mikroelektromechanischen Feldmühle F₁,
- Figur 4: zeigt das entsprechende Schaltbild für die Messdatenerfassung und
- Figur 5: zeigt die Anordnung der Messelektroden 31 einer mikroelektromechanischen Feldmühle im elektrischen Feldverlauf E.
- Figur 6: zeigt wiederum das Schaltbild des mikroelektromechanischen Elektroskops und
- Figur 7: zeigt die Anordnung der Messelektroden 41 eines mikroelektromechanischen Elektroskops im elektrischen Feld E.

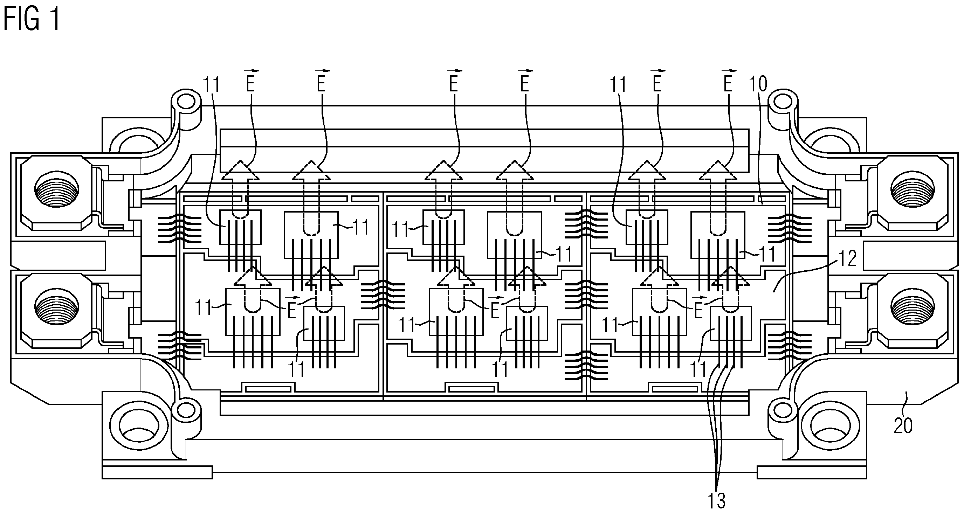

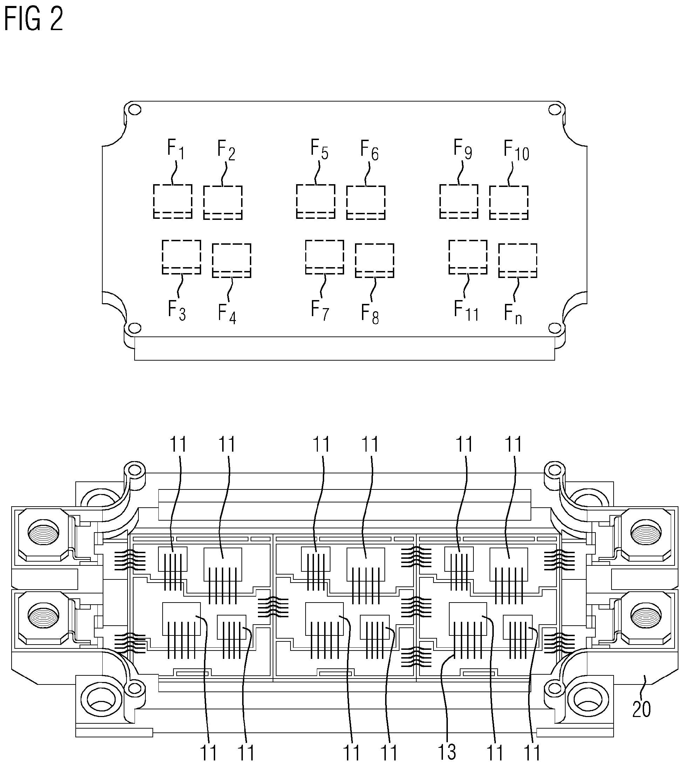

In den Figuren 1 und 2 ist schematisch ein Leistungsmodul 10 gezeigt, welches in einem Gehäuse 20 angeordnet ist. Dabei ist die Platine 12, bevorzugt ein elektrisch leitfähiges Substrat 12, in das Gehäuse 20 eingebettet und die elektrischen Anschlüsse sind seitlich aus dem Gehäuse 20 herausgeführt. Auf der Platine 12 sind stark vereinfacht einzelne Bauelemente 11 skizziert, welche z. B. Halbleitermodule 11 sein können. Diese sind über Bonddrähte 13 elektrisch mit dem leitfähigen Substrat der Platine 12 verbunden. Solche Bonddrähte 13 stellen häufig Fehlerstellen dar, da diese im laufenden Betrieb der elektronischen Baugruppe 10, insbesondere unter Hitzeentwicklung, materialtechnisch stark beansprucht werden und reißen oder sich von der Platine 12 ablösen können. Eine derartige Veränderung würde sich auf das elektrische Feld E, das von einem Bauelement 11 im Betrieb, unter Bestromung bzw. unter Spannung und entsprechend elektrischer Aufladung ausgeht, verändern. Die von den Bauelementen 11 ausgehenden elektrischen Felder E sind durch gestrichelte Pfeile in der Skizze angedeutet. In der Darstellung der Figur 2 ist das Gehäuse 20 dann um den Deckel ergänzt, in welchem die Feldmesseinrichtungen Fi bis Fₙ angeordnet sind. Im vorliegenden Beispiel sind die Feldmesseinrichtungen F₁ bis F₁₂ jeweils oberhalb der zu überwachenden Bauelemente 11 angeordnet. Als Feldmesseinrichtungen Fi bis Fₙ kommen bevorzugt mikroelektromechanische Feldmühlen oder mikroelektromechanische Elektroskope in Frage. Die Platzierung der elektrischen Feldmesseinrichtungen F₁ bis Fₙ erfolgt kontaktlos, d. h. ohne direkten elektrischen Kontakt zum überwachenden Bauteil 11 oder zur Baugruppe 10 oder zur Platine 12. Dafür ist besonders der Gehäusedeckel geeignet. Gleichzeitig sind die Feldmesseinrichtungen Fi bis Fₙ dann nahe genug, aber beabstandet angeordnet, sodass ein verändertes elektrisches Feld E durch die Feldmesseinrichtung registrierbar ist. Außer Defekten an den Bonddrähten 13 können auch Defekte am Chip 11, Delaminationen, Risse oder Defekte in der Lotanbindung der Bauteile 11 an die Platine 12 zu Veränderungen im elektrischen Feld E führen, welche durch die elektrischen Feldmesseinrichtungen F₁ bis Fₙ direkt messbar sind.

Bei dem zu detektierenden elektrischen Feld E kann es sich um ein statisches elektrisches Feld E, aber auch um ein zeitlich veränderliches elektrisches Feld E(t) handeln. Die bevorzugt eingesetzten Feldmesseinrichtungen Fi bis Fₙ wie Feldmühle oder Elektroskop sind geeignet auch zeitlich veränderliche E-Felder E(t) zu messen.

Sollten die elektrischen Feldmesseinrichtungen Fi bis Fₙ nicht in oder am Gehäuse 20 als gemeinsamen Träger für Feldmesseinrichtungen Fi bis Fₙ und zu überwachende Bauelemente 11 bzw. zu überwachende Baugruppe 10 erfolgen, könnten die elektrischen Feldmesseinrichtungen Fi bis Fₙ beispielsweise auch benachbart zu den Bauelementen 11 mit auf der Platine 12 platziert werden. Dann wäre auf eine ausreichende Beabstandung zu den elektrischen Bauelementen 11 und auf eine elektrische Isolation zu achten.

Durch die Erfindung wird im Gegensatz zu Lebensdauermodellen, die auf Temperatur oder Zyklen basieren, die Degradation in Bonddrähten und Lotschichten direkt bestimmt. Ein weiterer großer Vorteil der Erfindung ist, dass im Vergleich zu bisherigen Methoden mit sehr niedrigem Aufwand eine In-Situ-Lösung realisiert wird. Mit mikroelektromechanischen Feldmühlen oder mikroelektromechanischen Elektroskopen ist eine Integration einer derartigen Überwachungsmethode in eine Baugruppe 10 möglich.

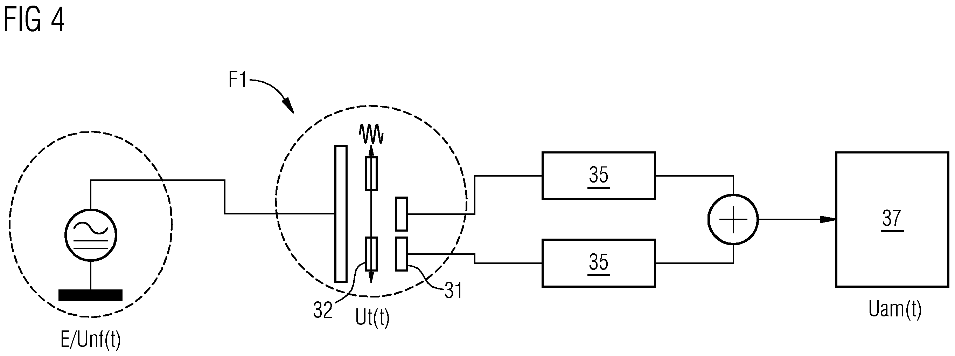

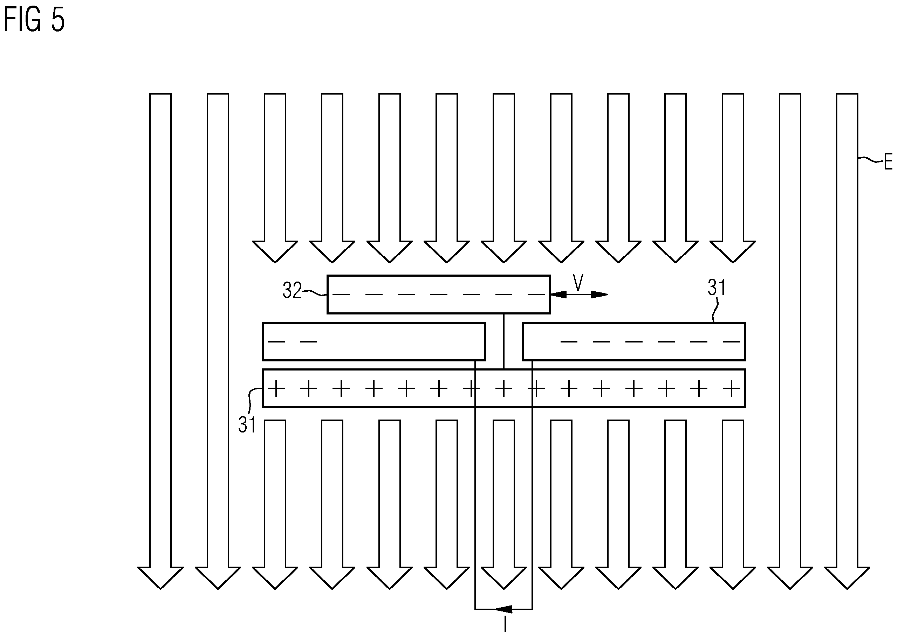

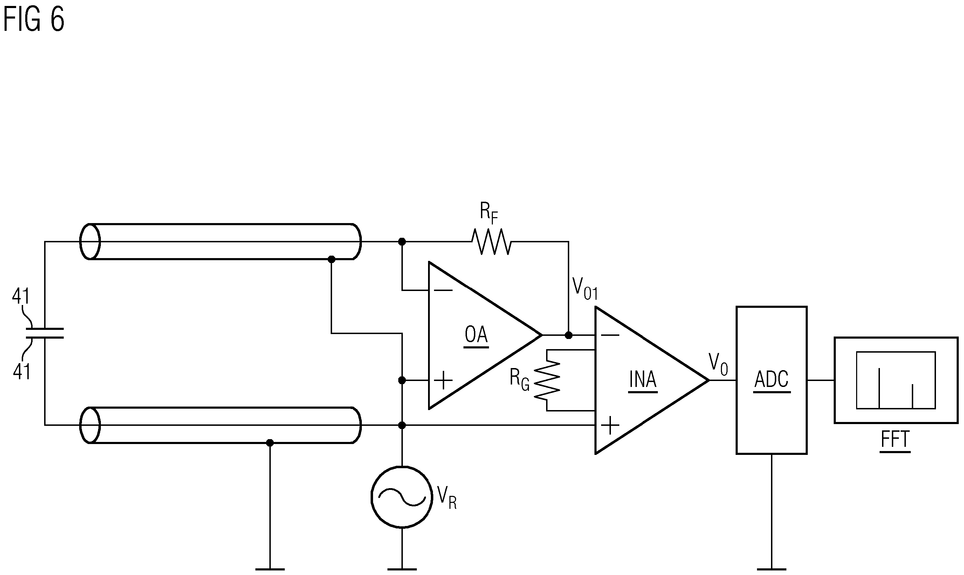

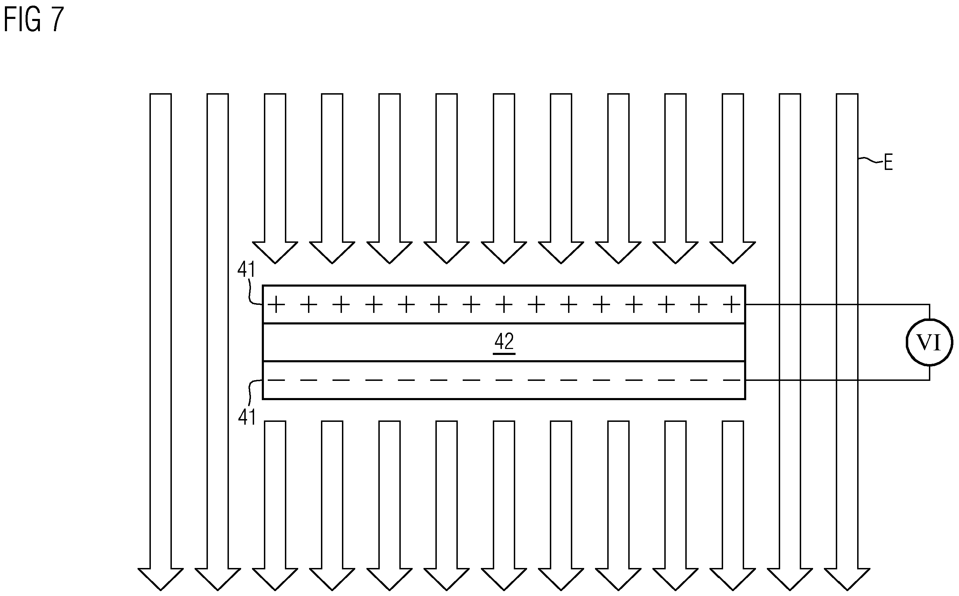

In den Figuren 4 und 6 sind Schaltbilder für die unterschiedlichen Messvarianten von elektrischer Feldmühle und Elektroskop gezeigt. In beiden Fällen werden, wie in den Figuren 5 und 7 gezeigt, Messelektroden 32, 31, 41 im elektrischen Feld E des zu überwachenden Bauteils oder Bauelements 11 platziert. In beiden Messmethoden werden kapazitive Ladungsverschiebungen als Strom gemessen. Bei der elektrischen Feldmühle wird ein unterschiedlicher Spannungsabgriff registriert, beim Elektroskop wird ein Verschiebungsstrom gemessen. Die Feldmesseinrichtungen Fi bis Fₙ werden also möglichst nahe an den zu überwachenden stromführenden Elementen der zu überwachenden Baugruppe 10 platziert. Diese das zu überwachende elektrische Feld generierende Elemente können Bauelemente 11, aber auch die Bonddrähte 13 sein. Die Feldmesseinrichtungen Fi bis Fₙ sind dabei so platziert, dass sie keinen elektrischen Kontakt haben und auch einen Mindestabstand, um zu gewährleisten, dass kein elektrischer Überschlag stattfinden kann.

Bei einer Alternativlösung mit Platzierung der elektrischen Feldmesseinrichtungen F₁ bis Fₙ auf dem Chip 11 bzw. auf der Platine 12 ist es auch denkbar, die Feldmesseinrichtungen F₁ bis Fₙ rückseitig, also auf der Unterseite der Baugruppe 10 zu platzieren, bevorzugt unter den Bauelementen 11 oder den Bonddrähten 13.

Die Auswerteelektronik ist bevorzugt außerhalb der Baugruppe 10, z. B. des Leistungsmoduls platziert. In den meisten Fällen befindet sich auch die Steuerelektronik der Baugruppe bzw. des Leistungsmoduls 10 außerhalb und ist nicht zusammen mit der Baugruppe 10 im selben Gehäuse 20 enthalten. Zweckdienlicherweise wird die Auswerteelektronik für die Feldmesseinrichtungen Fi bis Fₙ in die Steuerelektronik integriert. Diese kann auf einer separaten Platine untergebracht sein. Integriert man die Auswerteelektronik in die Steuerelektronik können Platz und Gewicht sowie Produktionskosten eingespart werden. Dies ist von besonderem Vorteil für den Einsatz entsprechender Leistungsmodule 10 in beweglichen Anwendungen. Die Platzierung und entsprechende Ortsauflösung von mehreren verteilt angebrachten elektrischen Feldmesseinrichtungen Fi bis Fₙ hat den Vorteil, dass die Defektstelle direkt lokalisiert werden kann. Mittels des erfindungsgemäßen Verfahrens ist also feststellbar, welcher Bonddraht 13 abgerissen ist.

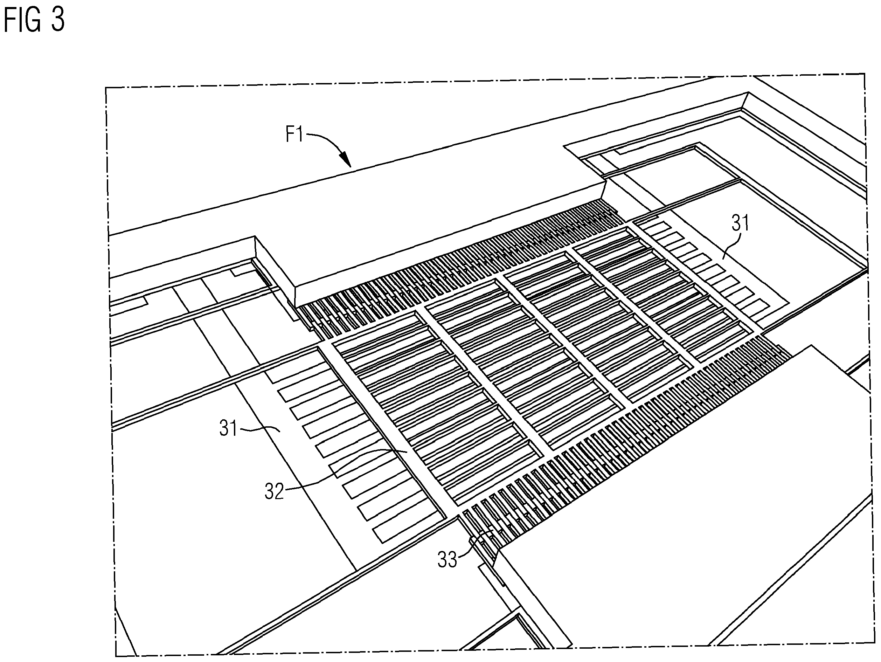

In den Figuren 3 bis 7 ist ein Überblick über die zwei bevorzugten Sensorvarianten zur elektrischen Feldbestimmung E gezeigt. Das elektrische Feld E bewirkt in den Sensorelektroden 31, 41 Ladungsverschiebungen, durch Plus- und Minus-Zeichen in der Graphik angedeutet. Im Fall der elektrischen Feldmühle sind, wie in Figur 3 gezeigt, die Sensorelektroden 31 bevorzugt als Fingerelektroden ausgeführt. Zusätzlich umfasst die mikroelektromechanische Feldmühle eine Elektrodenabschirmung 32, einen sogenannten Shutter, welcher beweglich angeordnet ist und mittels des Aktuators 33 bewegt wird. In der Darstellung der Figur 3 ist eine schematische Konstruktionszeichnung für ein mikroelektromechanisches Voltmeter gezeigt Fi. Es handelt sich um zwei elektrisch gegeneinander isolierte Kondensatorflächen 31, welche als Fingerelektroden ausgebildet sind und welche durch eine Verstärkerschaltung, wie in Figur 4 gezeigt, miteinander verbunden sind. Räumlich planparallel über den Kondensatorelektroden 31 bzw. in Richtung der Quelle des zu messenden elektrischen Feldes E ist eine schwingende Shutter-Elektrode 32 angeordnet, welche auf einem neutralen Bezugspotenzial liegt. Diese schwingende Elektrode 32 schattet je nach Auslenkung einen der beiden Kondensatorelektroden 31 vom elektrischen Feld E des externen zu vermessenden Bauteils 11 oder elektrischen Leiters, insbesondere eines Bonddrahts 13, ab. Relativ zur Stärke des externen elektrischen Feldes E fließt ein Strom bei jedem Schwingungsdurchgang der Shutter-Elektrode 32. Die Vorzeichen der Ströme beider Kondensatorelektroden 31 sind dabei stets gegensätzlich. Die Differenz dieser Stromflüsse ist proportional zum elektrischen Feld E des Bauteils 11 oder Leiters 13 und kann durch die Verstärkerschaltung, wie in Figur 4 gezeigt, gemessen werden. Dieses elektrische Feld E wiederum ist abhängig von der elektrischen Spannung bzw. dem elektrischen Strom, der einen Leiter 13 durchfließt oder an einem elektrischen Bauteil 11 anliegt.

Die in Figur 4 gezeigte Schaltung entspricht einer analogen Signalverarbeitungseinrichtung. In diesem Schaltbild ist stark simplifiziert gezeigt, wie die Voltmeterelektroden 31 abgeschirmt werden können.

Das Prinzip des Messvoltmeters, auch bezeichnet als mikroelektromechanische Feldmühle, beruht auf einer Messung der zeitlichen Veränderung einer elektrischen Kapazität mittels eines mikroelektromechanischen Systems. Die zeitliche Veränderung der Kapazität wird mechanisch mit einem elektrischen, elektrostatischen oder thermischen Aktor 33 herbeigeführt. Um die Veränderung der Kapazität zu messen, wird ein Verschiebungsstrom durch einen Stromspannungswandler 35 erfasst und hierdurch ein Messsignal Uam(t) generiert. Der Einfluss des zu messenden elektrischen Feldes E auf das Messergebnis Uam(t) wird dadurch eliminiert, dass die Spannung konstante Anteile enthält und der Stromspannungswandler 35 während der Schaltflanken der Spannung abgetastet wird. So kann eine Impulsantwort auf Spannungsänderungen bzw. Änderungen im elektrischen Feld E, wie auch auf dem Messkondensator 31 wirken, ausgeblendet werden. Es wird die Eigenschaft des kapazitiven Messprinzips genutzt, dass ein Signal nur detektiert werden kann, wenn sich am Kondensator 31 Ladungen verschieben, die einen Verschiebungsstrom I(t) initiieren. Hierfür gilt die Gleichung I(t) = dC/dT • U + dU/dT • C, wobei C die Kapazität des Kondensators 31 ist und U die am Kondensator 31 anliegende Spannung. Die Kapazität des Kondensators 31 bzw. die Kapazität zwischen einem Messobjekt, beispielsweise einem stromführenden Leiter 13, und dem Sensor F₁ bis Fₙ, kann durch Änderung der Fläche der Kondensatorelektroden 31, insbesondere durch Einschieben der Elektrodenblende 32 in den Kondensatorspalt, durch Änderung des Abstands der Kondensatorelektroden 31 oder durch Änderung der relativen Dielektrizitätskonstante des zwischen den Platten 31 befindlichen Dielektrikums geändert werden.

Vorzugsweise wird eine Messung also eine Überwachung im Betrieb der Baugruppe 10 vorgenommen. Um sicherzustellen, dass die dann gemessenen Überwachungsdaten verlässlich sind, kann der Abgleich mit Referenzwerten erfolgen. Beispielsweise ist dafür eine Testphase realisiert, diese kann auch zeitlich wiederkehrend sein, beispielsweise einmal pro Tag unter gleichen Bedingungen und gleicher angelegter Spannung. Es kann sich aber auch um eine einmalige Testphase vor Inbetriebnahme handeln. Ein derartiger Datenabgleich mit Referenzdaten erhöht die Verlässlichkeit der Überwachung.

In den Figuren 6 und 7 ist nun noch die Schaltung der alternativen Feldmesseinrichtung F₁ bis Fₙ, nämlich der des Elektroskops, insbesondere des mikroelektromechanischen Elektroskops gezeigt. In Figur 7 sind die Messelektroden 41 wie in einer Kondensatoranordnung mit einem dazwischenliegenden Dielektrikums 42 angeordnet und idealerweise senkrecht zu den Feldlinien des elektrischen Feldes E angeordnet. Eine durch das Feld induzierte Ladungsverschiebung in den Elektroden 41 ist als Strom messbar. In dem Schaltbild in Figur 6 ist eine kontaktlose Spannungsmessung V₀ gezeigt. Die Messelektroden bzw. Messkondensatoren 41 müssen entsprechend in dem zu überwachenden elektrischen Feld E platziert sein, d. h. möglichst nahe an dem zu überwachenden stromführenden Bauteil oder Leiter 13, aber ohne elektrischen Kontakt zu diesem, also elektrisch isoliert. Besonders zweckdienlich sind die Messelektroden 41 als Mikroplattenstruktur ausgestaltet.

Das Elektroskop detektiert elektrische Ladungen, in der makroskopischen klassischen Variante durch die Bewegung von dünnen Metallfolien oder dünnen Metallelektroden, die sich aufgrund der elektrostatischen Abstoßung voneinander wegbewegen. Die relative Stärke der Ladung wird durch die Auslenkung sichtbar.

Bei der miniaturisierten Version, der mikroelektromechanischen Variante des Elektroskops, beruht das Messprinzip auch darauf, das zu überwachende elektrische Feld E derart zu erfassen, dass Ladungsverschiebungen gemessen werden. Eine Änderung der elektrischen Ladung der Messelektroden 41 führt zu einer Veränderung der Kapazität der Kondensatoranordnung aus diesen Elektroden 41. Diese Änderung kann sehr genau gemessen werden, indem die Ladung oder Entladung der Kondensatorelektroden 41 über die in Figur 6 gezeigte Schaltung erfasst wird. Als Variante kann das Dielektrikum 42 so angepasst werden, dass eine gewisse minimale Leitfähigkeit besteht, die den Effekt der Ladungsverschiebung auf den Platten 41 begünstigt und so die Messgenauigkeit erhöht.

Auch beim Elektroskop, vergleiche Messschaltung in Figur 6 und Anordnung der Messelektroden 41 im elektrischen Feld E in Figur 7, erfolgt eine Messung, eine Signalverstärkung, insbesondere eine Signalfilterung und optional eine Signal-Verarbeitung, z.B. mittels FFT von elektrischen Signalen wie Strom und/oder Spannung, gemäß bewährten Standardvorgehen in der Messtechnik. Die finale Messgröße V_{O} ist dann eine Spannung, welche als Feldstärkesignal proportional zur Feldstärke E des gemessenen elektrischen Feldes ist. ADC und FFT sind beispielhafte Möglichkeiten für eine Auswertung.

Ein besonderer Vorteil der vorgeschlagenen elektrischen Felderfassung besteht darin, dass nicht nur ein elektrostatisches, sondern auch ein zeitlich veränderliches elektrisches Feld E(t) gleichermaßen erfasst wird. Alterungserscheinungen in den Bonddrähten 13 oder den Lotschichten unter den Bauelementen 11 ergeben eine veränderte Charakteristik des statischen sowie des zeitabhängigen elektrischen Feldes E(t). Es wird in regelmäßigen Abständen im Betrieb gemessen, sodass dann eine Alterung durch Anomalien in diesen Messdaten festzustellen ist. Bevorzugt wird an mehreren Stellen gemessen, um eine Ortsauflösung zu erhalten.

Erhält man im gesunden Zustand des Moduls 10 beispielsweise an der Feldmesseinrichtung Fₙ einen gewissen Signalpegel, eine gewisse Messspannung mit einer entsprechenden Messgenauigkeit, so wird im Falle eines Bondlifts eines Bonddrahts 13 oder einer teilweisen Delamination des Lots dieser Spannungspegel sinken. Als Referenz können die vorangegangenen Messungen dienen. Auch die Verknüpfung der Daten mit mehreren verteilt angeordneten Feldmühlen bzw. Feldmesseinrichtungen Fi bis Fₙ ist möglich. Ein Abgleich mit zeitgleich Messdaten aufnehmenden Feldmesseinrichtungen F₁ bis Fₙ erhöht die Genauigkeit der Überwachung.

Ein weiterer besonderer Vorteil der Erfassung von statischem und zeitlich veränderlichem statischem Feld E(t) liegt beispielsweise darin, dass sich unterschiedliche Defekte unterschiedlich auf statisches oder Wechselfeld auswirken. Beispielsweise würde ein Bondlift sich im zeitlich veränderlichen elektrischen Feld E(t) beispielsweise im Wechselfeld durch Stromfluss durch diesen Drahtbond stärker bemerkbar machen als in einem elektrostatischen Feld E.

Das Prinzip der Feldmühle beruht darauf, dass eine erste Elektrode 31 fixiert und eine zweite Elektrode 31, insbesondere in Fingerstruktur beweglich gegen diese erste statisch angeordnete Elektrode 31 angebracht ist. Die bewegliche Elektrode 31 wird mit einer Geschwindigkeit v bewegt. Die bewegliche Elektrode 31 kann in einer Schwingungsbewegung bewegt werden, welche beispielsweise durch eine Federlagerung realisiert sein kann. Die Schwingungsanregung kann beispielsweise über ein Steuersignal erfolgen. Dies kann beispielsweise ein Spannungsimpuls sein. Zweckdienlich werden Frequenzen um die 10 kHz verwendet.

### Bezugszeichen:

- 10: Elektronische Baugruppe, insbesondere leistungselektronische Baugruppe
- 11: Halbleitermodul/Bauelement
- 12: Kupfersubstrat, elektrisch leitfähiges Substrat, Platine
- 13: Bonddrähte
- 20: Gehäuse
- 21: Gehäusedeckel
- F₁-Fₙ: Feldmesseinrichtung(en), z.B. Feldmühle(en), insbesondere MEMS-Feldmühle(en)
- E: E-Feld, elektrisches Feld, ausgehend von Bauelementen 11 sowie Bonddrähten 13
- E(t): zeitlich veränderliches E-Feld, ausgehend von Bauelementen 11 sowie Bonddrähten 13
- 31: MEMS-Elektroden
- 32: Elektrodenabschirmung, Shutter, beweglich angeordnet
- 33: Aktuator
- 35: I/U-Wandler, I=Verschiebungsstrom, U=Signalausgabe, bzw. das Feldstärkesignal
- 37: Signalausgabe, Feldstärkesignal
- I: Strom, Strommessung
- v: Bewegung mit Geschwindigkeit v in Pfeilrichtung
- U_{nf}(t): modulierendes Nutzsignal
- Uₜ(t): unmodulierter Träger
- Uₐₘ(t): modulierter Träger
- 41: Sensorelektroden
- 42: Dielektrikum
- V_{R}: regelbare Wechselspannung
- OA: Operationsverstärker
- R_{F}: Messwiderstand
- V_{O1}: Ausgangsspannung am OA
- R_{G}: Shunt
- INA: Instrumentenverstärker, der intern aus mehreren Operationsverstärkern besteht, um höhere Messgenauigkeiten zu erzielen
- V_{O}: Messspannung des E-Feldes bzw. Feldstärkesignal, maßgeblicher Spannungswert zur Bestimmung des elektrischen Feldes
- ADC: Analog-Digital-Converter, optional zur Auswertung
- FFT: Fast Fourier Transformation, optionaler Algorithmus zur Signalauswertung
- VI: Verweis auf Fig. 6, hier schließt die Messschaltung an

## Patentansprüche

1. Verfahren zur Überwachung einer elektronischen Baugruppe (10), bei dem eine elektrische Feldmessung vorgenommen wird, bei welcher elektrischen Feldmessung ein elektrisches Feld (E, E(t)) wenigstens eines Bauelements (11) der elektronischen Baugruppe (10) erfasst wird,
wobei die erfassten elektrischen Felddaten (E, E(t)) in einem Messauswertungsvorgang ausgewertet werden und Änderungen am Bauelement (11) indizieren.

2. Verfahren nach Anspruch 1, wobei die elektrische Feldmessung mittels einer elektrischen Feldmühle (F₁-Fₙ), insbesondere mittels einer mikroelektromechanische Feldmühle (F₁-Fₙ), vorgenommen wird.

3. Verfahren nach Anspruch 1, wobei die elektrische Feldmessung mittels eines Elektroskops (F₁-Fₙ), insbesondere mittels eines mikroelektromechanischen Elektroskops, vorgenommen wird.

4. Verfahren nach Anspruch 1, 2 oder 3, wobei im Messauswertungsverfahren die erfassten elektrischen Felddaten (E, E(t)) mit Referenzdaten abgeglichen werden.

5. Verfahren nach Anspruch 4, wobei eine Referenzmessung des elektrischen Feldes vor Inbetriebnahme der elektronischen Baugruppe (10) vorgenommen wird und deren Daten die Referenzdaten bilden.

6. Verfahren nach einem der vorstehenden Ansprüche, wobei die indizierten Änderungen am Bauelement Schäden oder Delaminationen der Bonddrähte und/oder der Lotschicht(en) sind.

7. Verfahren nach einem der vorstehenden Ansprüche, wobei die elektrische Feldmessung zu diskreten Zeitpunkten vorgenommen wird oder kontinuierlich vorgenommen wird.

8. Verfahren nach einem der vorstehenden Ansprüche, wobei die elektrische Feldmessung beabstandet vorgenommen wird, wobei die Beabstandung einer Feldmesseinrichtung (F₁-Fₙ) mittels Befestigung an einem mit der zu überwachenden elektronischen Baugruppe gemeinsamen Träger (12, 20) erfolgt.

9. Bauelement (11), insbesondere Halbleitermodul oder Leistungshalbleitermodul, angeordnet mit einer elektrischen Feldmesseinrichtung (F₁-Fₙ), welche elektrische Feldmesseinrichtung (F₁-Fₙ) ausgestaltet ist, ein vom Bauelement (11) im Betrieb ausgehendes elektrisches Feld (E, E(t)) zu messen und die erfassten elektrischen Felddaten (E, E(t)) an eine Messauswerteelektronik zu übertragen.

10. Bauelement (11), nach Anspruch 9, wobei die elektrische Feldmesseinrichtung (F₁-Fₙ) eine elektrische Feldmühle ist, insbesondere eine mikroelektromechanische Feldmühle, welche wenigstens zwei Fingerelektroden (31), eine Elektrodenabschirmung (32) und einen Aktuator (33), I/U-Wandler (35) sowie Signalausgabe des Feldstärkesignals (37, V₀) aufweist.

11. Bauelement (11), nach Anspruch 9, wobei die elektrische Feldmesseinrichtung (F₁-Fₙ) ein Elektroskop ist, insbesondere ein mikroelektromechanisches Elektroskop, welches wenigstens zwei Elektroden (41), ein Dielektrikum (42) zwischen den zwei Elektroden (41), eine Messschaltung zur Erfassung eines Lade- oder Entladestroms der zwei Elektroden (41) sowie eine Signalausgabe des Feldstärkesignals (37, V₀) aufweist.

12. Elektronische Baugruppe (10), insbesondere leistungselektronische Baugruppe, umfassend wenigstens ein Bauelement (11) gemäß Anspruch 9, wobei wenigstens eine elektrische Feldmesseinrichtung (F1-Fn) an einem, mit dem zu überwachenden elektronischen Bauelement (11) gemeinsamen, Träger (12, 20) befestigt ist.

13. Elektronische Baugruppe (10) nach Anspruch 12, mit einer Messauswerteelektronik, welche derart ausgestaltet ist, die von wenigstens einer elektrischen Feldmesseinrichtung (F₁-Fₙ) erfassten elektrischen Felddaten (E, E(t)) zu empfangen und auszuwerten.

14. Elektronische Baugruppe (10) nach Anspruch 12 oder 13, umfassend eine Vielzahl an elektrischen Feldmesseinrichtungen (F₁-Fₙ), welche so angeordnet sind, dass die damit erfassten elektrischen Felddaten (E, E(t)) in einem Messauswertungsvorgang ausgewertet werden und ortsaufgelöst Änderungen an der elektronischen Baugruppe (10) indizieren.

15. Elektronische Baugruppe (10) nach einem der Ansprüche 12 bis 14, in einem Gehäuse (20), wobei das Gehäuse (20) als gemeinsamer Träger fungiert, und wobei die elektrischen Feldmesseinrichtungen (F₁-Fₙ) insbesondere so im Gehäusedeckel (21) angebracht sind, dass die elektrischen Feldmesseinrichtungen (F₁-Fₙ) im geschlossenen Zustand des Gehäuses (20) geeignet beabstandet zu den zu prüfenden Bauelementen (11) angeordnet sind.
